# DEMANDE DE BREVET EUROPEEN

(11) **EP 4 521 886 A1**
(43) Date de publication de la demande: **12.03.2025**
(21) Numéro de dépôt: 24198340.2
(22) Date de dépôt: 04.09.2024
(51) Int. Cl.: H10F 71/00, H10F 77/30, H10F 77/20

(54) **PROCÉDÉ DE PASSIVATION DE CELLULES PHOTOVOLTAÏQUES**

(30) Priorité: 05.09.2023 FR 2309302
(71) Demandeur: Commissariat à l'Energie Atomique et aux Energies Alternatives, 75015 Paris (FR)
(72) Inventeur: HARRISON, Samuel, 38054 GRENOBLE CEDEX 09 (FR); ALBARIC, Mickaël, 38054 GRENOBLE CEDEX 09 (FR); MARTEL, Benoît, 38054 GRENOBLE CEDEX 09 (FR)
(74) Mandataire: Cabinet Camus Lebkiri

(57) **Abrégé**

L'invention concerne un procédé de passivation de cellules photovoltaïques (5) comprenant des étapes de :
- fourniture d'une pluralité de cellules, chaque cellule (5) comprenant une face avant (5A), une face arrière (5B) et un bord périphérique (5C), chaque cellule (5) étant munie d'une pluralité de premières pistes conductrices d'interconnexion (8A, 9A, 10A) et d'une pluralité de deuxièmes pistes conductrices d'interconnexion (10) parallèles,
- empilement des cellules, la pluralité de premières pistes et la pluralité de deuxièmes pistes de chaque cellule étant positionnées entre la cellule concernée et une cellule adjacente, et
- dépôt d'une couche de passivation sur le bord périphérique (5C) des cellules par injection d'une espèce de passivation, la pluralité de premières pistes et la pluralité de deuxièmes pistes formant une barrière de pénétration à l'espèce de passivation.

## Description

### DOMAINE TECHNIQUE

La présente invention concerne de manière générale la fabrication de cellules photovoltaïques.

L'invention concerne plus particulièrement un procédé de passivation de cellules photovoltaïques.

### ÉTAT DE LA TECHNIQUE

Un module photovoltaïque comprend une multitude de cellules photovoltaïques identiques connectées en série et/ou en parallèle afin de fournir en sortie la tension et/ou le courant requis pour alimenter des dispositifs électriques. Le format de module le plus courant emploie 60 cellules carrées (ou « pseudo-carrées »), de 156 mm de côté, réparties en six chaînes (« strings » en anglais) de dix cellules connectées en série. Les six chaînes de cellules photovoltaïques sont également connectées en série. La tension de circuit ouvert aux bornes du module est alors égale à 60 fois la tension de seuil d'une cellule photovoltaïque. Le courant électrique du module correspond approximativement au courant fourni par chaque cellule photovoltaïque (en pratique, les cellules photovoltaïques n'ont pas exactement les mêmes performances et le courant électrique est limité par la cellule la moins performante du module).

Avec les dernières technologies de cellules photovoltaïques, notamment la technologie PERT (pour « Passivated Emitter and Rear Totally diffused » en anglais), le courant d'une cellule monofaciale de 156 mm x 156 mm en superficie atteint des valeurs élevées, de l'ordre de 9 A pour une irradiance solaire de 1000 W/m². Ces valeurs de courant sont augmentées d'environ 20 % lorsqu'on utilise une cellule bifaciale, du fait du rayonnement solaire diffus capté en face arrière de la cellule. Ce fort courant électrique circule dans les éléments d'interconnexion entre les cellules du module et occasionne des pertes résistives importantes.

Afin de réduire ces pertes résistives, une solution consiste à assembler des modules avec des cellules photovoltaïques de superficie plus faible, et donc de courant plus faible. Ces cellules de plus faible superficie sont communément appelées « sous-cellules » et sont obtenues par découpage de cellules photovoltaïques de pleine taille (ex. 156 mm x 156 mm).

Cependant, le découpage d'une cellule photovoltaïque crée de nouveaux bords qui se retrouvent à nu. Par ailleurs, le découpage (au laser par exemple) est susceptible de créer des défauts et d'introduire des impuretés à proximité du plan de coupe. Ces défauts et impuretés diminuent la durée de vie des porteurs de charge libres en agissant comme centres de recombinaison des paires électron-trou, ce qui se traduit par une diminution du rendement de la cellule. Ce phénomène est particulièrement prononcé pour les cellules photovoltaïques à hétérojonction (HET), qui possèdent par nature très peu de défauts de surface et où la création de quelques défauts localisés suffit à réduire les performances électriques de la cellule de manière significative.

Il est notamment connu du document FR3091025 un procédé de passivation de cellules photovoltaïques permettant de localiser le dépôt d'un matériau de passivation au voisinage d'un bord seulement de la cellule photovoltaïque.

Pour être compatible avec les exigences d'une production industrielle, tout en déposant un matériau de passivation uniquement sur les bords des cellules photovoltaïques, le document FR3091025 décrit un agencement consistant à empiler une pluralité de cellules photovoltaïques les unes sur les autres, l'empilement reposant directement sur un support.

Selon cet agencement, les faces avant et arrière de chaque cellule photovoltaïque sont donc en contact direct avec l'une des faces d'une autre cellule photovoltaïque ou avec le support. Ce contact direct entraîne des risques de dégradations de ces faces avant et arrière, et en particulier des métallisation présentes sur ces faces avant et/ou arrière. Cela entraîne alors une dégradation des performances électriques.

De plus, avec cet agencement, il y a un risque de dépôt de la couche de passivation sur les métallisations, ce qui induit une résistance locale supplémentaire. Cette couche de passivation formée sur les métallisations empêche alors le passage des charges électriques entre les cellules photovoltaïques dans un module photovoltaïque.

### RÉSUMÉ DE L'INVENTION

La présente invention vise donc à améliorer la fabrication des cellules photovoltaïques en s'assurant notamment que le processus de passivation des cellules photovoltaïques ne dégrade pas les cellules photovoltaïques elles-mêmes, et en particulier les métallisations de ces cellules photovoltaïques, ni les performances électriques associées.

L'invention concerne alors tout d'abord un procédé de passivation de cellules photovoltaïques comprenant des étapes de :
- fourniture d'une pluralité de cellules photovoltaïques, chaque cellule photovoltaïque comprenant une face avant, destinée à être exposée à un rayonnement incident, une face arrière opposée à la face avant et un bord périphérique reliant la face avant et la face arrière, chaque cellule photovoltaïque étant munie, sur la face avant ou la face arrière, d'une pluralité de premières pistes conductrices d'interconnexion et d'une pluralité de deuxièmes pistes conductrices d'interconnexion, la pluralité de deuxièmes pistes conductrices d'interconnexion s'étendant parallèlement à la pluralité de premières pistes conductrices d'interconnexion, une pluralité de couples de pistes conductrices d'interconnexion étant formée, chaque couple de pistes conductrices d'interconnexion comprenant une première piste conductrice d'interconnexion parmi la pluralité de premières pistes conductrices d'interconnexion et une deuxième piste conductrice d'interconnexion parmi la pluralité de deuxièmes pistes conductrices d'interconnexion,
- empilement de la pluralité de cellules photovoltaïques, la pluralité de premières pistes conductrices d'interconnexion et la pluralité de deuxièmes pistes conductrices d'interconnexion de chaque cellule photovoltaïque étant positionnées entre la cellule photovoltaïque concernée et une cellule photovoltaïque adjacente de telle manière que la face de la cellule photovoltaïque munie de la pluralité de premières pistes conductrices d'interconnexion et de la pluralité de deuxièmes pistes conductrices d'interconnexion soit positionnée à distance de la face en regard de la cellule photovoltaïque adjacente, et
- dépôt d'une couche de passivation sur le bord périphérique des cellules photovoltaïques de la pluralité de cellules photovoltaïques par injection d'au moins une espèce de passivation.

Ainsi, de manière avantageuse selon l'invention, l'utilisation des pistes électriquement conductrices d'interconnexion permet d'empiler les cellules photovoltaïques sans que les faces avant et arrière de chaque cellule photovoltaïque ne soient en contact direct. Cela permet d'éviter des dégradations de performances électriques.

De plus, grâce à la configuration impliquant la formation de couples de busbars positionnés entre les cellules photovoltaïques adjacentes, la surface des pistes conductrices d'interconnexion n'est pas exposée à l'espèce de passivation (cette dernière n'est donc pas déposée sur la surface des pistes conductrices d'interconnexion). La surface des pistes conductrices d'interconnexion est donc protégée. Cela permet alors d'améliorer l'interconnexion entre les cellules photovoltaïques lors de la formation de modules photovoltaïques.

Cette absence de couche d'espèces de passivation sur les pistes conductrices d'interconnexion permet également de garantir la qualité de l'interconnexion entre les cellules photovoltaïques (aucune résistance locale supplémentaire, qui pourrait être induite par la présence de cette couche d'espèces de passivation sur les pistes conductrices d'interconnexion, n'est ajoutée). La colle conductrice permettant l'assemblage des cellules photovoltaïques est directement positionnée sur la surface des pistes conductrices d'interconnexion, favorisant alors le passage des charges électriques entre les cellules photovoltaïques du module photovoltaïque concerné.

Enfin, grâce au positionnement de la pluralité de premières pistes conductrices d'interconnexion et de la pluralité de deuxièmes pistes conductrices d'interconnexion, lorsque les cellules photovoltaïques sont empilées, seules les portions du bord périphérique parallèles aux pistes conductrices d'interconnexion de chaque cellule photovoltaïque sont visibles et accessibles depuis l'extérieur de l'empilement. En d'autres termes, le long de ces portions du bord périphérique, les pistes conductrices d'interconnexion (et en particulier les pistes conductrices d'interconnexion les plus proches de ces portions du bord périphérique) isolent le coeur de chaque cellule photovoltaïque de l'extérieur de l'empilement. Cela permet alors de s'assurer que, le long de ces portions, seul le bord périphérique des cellules photovoltaïques et une faible surface des faces avant et arrière (au niveau des portions du bord périphérique transversales aux pistes conductrices d'interconnexion) est exposé aux espèces de passivation pour le dépôt de la couche de passivation.

Outre les caractéristiques qui viennent d'être évoquées dans les paragraphes précédents, le procédé de passivation selon l'invention peut présenter une ou plusieurs caractéristiques complémentaires parmi les suivantes, considérées individuellement ou selon toutes les combinaisons techniquement possibles :
- pour chaque couple de pistes conductrices d'interconnexion, la première piste conductrice d'interconnexion parmi la pluralité de premières pistes conductrices d'interconnexion et la deuxième piste conductrice d'interconnexion parmi la pluralité de deuxièmes pistes conductrices d'interconnexion sont espacées d'une distance prédéterminée inférieure à 100 micromètres ;
- lors de l'étape d'empilement, les cellules photovoltaïques sont positionnées de telle manière que la pluralité de premières pistes conductrices d'interconnexion et la pluralité de deuxièmes pistes conductrices d'interconnexion sont en contact direct avec la face en regard de la cellule photovoltaïque adjacente ;
- chaque cellule photovoltaïque de la pluralité de cellules photovoltaïques comprend une pluralité d'électrodes positionnées transversalement à la pluralité de premières pistes conductrices d'interconnexion et à la pluralité de deuxièmes pistes conductrices d'interconnexion, chaque première piste conductrice d'interconnexion parmi la pluralité de premières pistes conductrices d'interconnexion et chaque deuxième piste conductrice d'interconnexion parmi la pluralité de deuxièmes pistes conductrices d'interconnexion présentant une largeur supérieure ou égale à la largeur de chaque électrode de la pluralité d'électrodes ;
- chaque cellule photovoltaïque comprend également une pluralité de troisièmes pistes conductrices d'interconnexion, la pluralité de troisièmes pistes conductrices d'interconnexion étant formée sur la face opposée à la face munie de la pluralité de premières pistes conductrices d'interconnexion et la pluralité de deuxièmes pistes conductrices d'interconnexion ;
- lors de l'étape d'empilement, les cellules photovoltaïques sont positionnées de telle sorte que chaque troisième piste conductrice d'interconnexion parmi la pluralité de troisièmes pistes conductrices d'interconnexion d'une cellule photovoltaïque est placée entre une première piste conductrice d'interconnexion et une deuxième piste conductrice d'interconnexion d'un couple de pistes conductrices d'interconnexion correspondant de la cellule photovoltaïque adjacente, chaque troisième piste conductrice d'interconnexion étant en contact direct avec la face de la cellule photovoltaïque adjacente sur laquelle sont formées la première piste conductrice d'interconnexion concernée et la deuxième piste conductrice d'interconnexion concernée ; et
- chaque cellule photovoltaïque comprend également une pluralité de quatrièmes pistes conductrices d'interconnexion et une pluralité de cinquièmes pistes conductrices d'interconnexion, la pluralité de cinquièmes pistes conductrices d'interconnexion s'étendant parallèlement à la pluralité de quatrièmes pistes conductrices d'interconnexion, la pluralité de quatrièmes pistes conductrices d'interconnexion et la pluralité de cinquièmes pistes conductrices d'interconnexion étant formées sur la face opposée à la face munie de la pluralité de premières pistes conductrices d'interconnexion et la pluralité de deuxièmes pistes conductrices d'interconnexion, la pluralité de quatrièmes pistes conductrices d'interconnexion étant positionnée en regard de la pluralité de premières pistes conductrices d'interconnexion et la pluralité de cinquièmes pistes conductrices d'interconnexion étant positionnée en regard de la pluralité de deuxièmes pistes conductrices d'interconnexion.

L'invention concerne également un procédé de passivation de cellules photovoltaïques comprenant des étapes de :
- fourniture d'une pluralité de cellules photovoltaïques, chaque cellule photovoltaïque comprenant une face avant, destinée à être exposée à un rayonnement incident, une face arrière opposée à la face avant et un bord périphérique reliant la face avant et la face arrière, chaque cellule photovoltaïque étant munie, sur la face avant, d'une première piste conductrice d'interconnexion positionnée parallèlement à une première portion du bord périphérique, chaque cellule photovoltaïque étant munie, sur la face arrière, d'une deuxième piste conductrice d'interconnexion positionnée parallèlement à une deuxième portion du bord périphérique, la première portion du bord périphérique et la deuxième portion du bord périphérique étant parallèles l'une à l'autre,
- empilement de la pluralité de cellules photovoltaïques, la première piste conductrice d'interconnexion et la deuxième piste conductrice d'interconnexion de chaque cellule photovoltaïque étant positionnées entre la cellule photovoltaïque concernée et une cellule photovoltaïque adjacente de telle manière que la face avant de la cellule photovoltaïque munie de la première piste conductrice d'interconnexion soit positionnée à distance de la face arrière de la cellule photovoltaïque adjacente munie de la deuxième piste conductrice d'interconnexion, et
- dépôt d'une couche de passivation sur le bord périphérique des cellules photovoltaïques de la pluralité de cellules photovoltaïques par injection d'au moins une espèce de passivation, la première piste conductrice d'interconnexion et la deuxième piste conductrice d'interconnexion formant une barrière de pénétration à l'espèce de passivation de sorte que la couche de passivation recouvre le bord périphérique de chaque cellule photovoltaïque.

Cette configuration est particulièrement avantageuse car elle permet d'empiler les cellules photovoltaïques sans que les faces avant et arrière de chaque cellule photovoltaïque ne subissent de contraintes. Cela permet d'éviter des dégradations de performances électriques.

De plus, grâce à la configuration impliquant des busbars positionnés entre les cellules photovoltaïques adjacentes, la surface des pistes conductrices d'interconnexion n'est pas exposée à l'espèce de passivation (cette dernière n'est donc pas déposée sur la surface des pistes conductrices d'interconnexion). La surface des pistes conductrices d'interconnexion est donc protégée. Cela permet alors d'améliorer l'interconnexion entre les cellules photovoltaïques lors de la formation de modules photovoltaïques.

Ce procédé de passivation est particulièrement adapté aux sous-cellules de superficie plus faible.

Outre les caractéristiques qui viennent d'être évoquées dans les paragraphes précédents, le procédé de passivation selon l'invention peut présenter une ou plusieurs caractéristiques complémentaires parmi les suivantes, considérées individuellement ou selon toutes les combinaisons techniquement possibles :
- lors de l'étape d'empilement, les cellules photovoltaïques sont positionnées de telle manière que la première piste conductrice d'interconnexion et la deuxième piste conductrice d'interconnexion sont en contact direct avec la face en regard de la cellule photovoltaïque adjacente ;
- chaque cellule photovoltaïque comprend une troisième piste conductrice d'interconnexion et une quatrième piste conductrice d'interconnexion, la troisième piste conductrice d'interconnexion étant formée sur la face avant munie de la première piste conductrice d'interconnexion, en parallèle de la première piste conductrice d'interconnexion, la quatrième piste conductrice d'interconnexion étant formée sur la face arrière munie de la deuxième piste conductrice d'interconnexion, en parallèle de la deuxième piste conductrice d'interconnexion, la troisième piste conductrice d'interconnexion étant formée à une distance prédéterminée de la première piste conductrice d'interconnexion et la quatrième piste conductrice d'interconnexion étant formée à ladite distance prédéterminée de la deuxième piste conductrice d'interconnexion ; et
- la distance prédéterminée est inférieure à 100 micromètres.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
La figure 1 est une vue du dessus d'une cellule photovoltaïque selon un premier exemple d'un premier mode de réalisation d'un procédé de passivation conforme à l'invention,
La figure 2 est une vue en coupe d'un empilement comprenant la cellule photovoltaïque de la figure 1,
La figure 3 représente une vue en coupe d'une cellule photovoltaïque selon un deuxième exemple du premier mode de réalisation du procédé de passivation conforme à l'invention,
La figure 4 est une vue en coupe d'un empilement comprenant la cellule photovoltaïque de la figure 3,
La figure 5 représente une vue en coupe d'une cellule photovoltaïque selon un troisième exemple du premier mode de réalisation du procédé de passivation conforme à l'invention,
La figure 6 est une vue en coupe d'un empilement comprenant la cellule photovoltaïque de la figure 5,
La figure 7 représente une vue en coupe d'une cellule photovoltaïque selon un premier exemple d'un deuxième mode de réalisation du procédé de passivation conforme à l'invention,
La figure 8 est une vue en coupe d'un empilement comprenant la cellule photovoltaïque de la figure 7,
La figure 9 représente une vue en coupe d'une cellule photovoltaïque selon un deuxième exemple du deuxième mode de réalisation du procédé de passivation conforme à l'invention, et
La figure 10 est une vue en coupe d'un empilement comprenant la cellule photovoltaïque de la figure 9.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

La présente invention vise à améliorer la fabrication de cellules photovoltaïques et en particulier à améliorer la phase de passivation de cellules photovoltaïques.

Les cellules photovoltaïques 5 ; 6 concernées par la présente invention sont par exemple des cellules 5 de pleine taille ou des sous-cellules 6, c'est-à-dire des portions ou morceaux d'une cellule photovoltaïque de pleine taille (aussi qualifiée de cellule photovoltaïque « entière »).

Les sous-cellules 6 sont de superficie plus faible que les cellules photovoltaïques 5 de pleine taille. Les sous-cellules 6 présentent par exemple un format communément appelé « shingle » (ou « half-cell »). Ces sous-cellules 6 sont par exemple préalablement obtenues par découpage de cellules photovoltaïques de pleine taille.

Les cellules photovoltaïques 5 de pleine taille ont été préalablement fabriquées à partir de substrats semi-conducteurs, par exemple en silicium cristallin. Ces substrats ont été initialement découpés dans un lingot de silicium, puis ont été soumis à plusieurs étapes de fabrication (par exemple des étapes de structuration de surface, dopage, recuit, passivation, sérigraphie...), mais aucune autre étape de découpage. Les cellules photovoltaïques 5 de pleine taille présentent des couches de passivation sur l'ensemble de ses faces et surfaces latérales.

Les cellules photovoltaïques 5 ; 6 concernées par la présente invention comprennent chacune une première face 5A ; 6A et une deuxième face 5B ; 6B, opposée à la première face 5A ; 6A. La première face 5A ; 6A est par exemple celle destinée à être exposée au rayonnement solaire incident. Dans ce cas, la première face 5A ; 6A correspond à la face avant 5A ; 6A de la cellule photovoltaïque 5 ; 6 concernée. La suite de cette description se base sur cet exemple en considérant, pour chaque cellule photovoltaïque 5 ; 6, la face avant 5A ; 6A (exposée au rayonnement solaire incident) et la face arrière 5B ; 6B (opposée à la face avant 5A ; 6A).

Chaque cellule photovoltaïque 5 ; 6 comprend également un bord périphérique 5C ; 6C reliant la face avant 5A ; 6A et la face arrière 5B ; 6B. Ce bord périphérique 5C ; 6C correspond donc à la surface latérale liant la face avant 5A ; 6A et la face arrière 5B ; 6B. Par définition ici, le bord périphérique 5C ; 6C s'étend donc sur l'ensemble du pourtour de la face avant 5A ; 6A et de la face arrière 5B ; 6B de la cellule photovoltaïque 5 ; 6. Dans la présente description, on entend par « pourtour » de la cellule photovoltaïque 5 ; 6, la ligne de contour de la face avant 5A ; 6A et/ou de la face arrière 5B ; 6B.

Vues de face (depuis la face avant 5A ; 6A ou la face arrière 5B ; 6B), les cellules photovoltaïques 5 ; 6 présentent de préférence une forme rectangulaire ou pseudo-rectangulaire. Dans le format pseudo-rectangulaire, les quatre coins des cellules photovoltaïques 5 ; 6 sont tronqués ou arrondis. En particulier, les cellules photovoltaïques 5 ; 6 peuvent présenter une forme carrée ou pseudo-carrée.

Le pourtour de la cellule photovoltaïque 5 ; 6 présente donc ici une forme rectangulaire ou pseudo-rectangulaire (ou, dans le cas particulier, carrée ou pseudo-carrée).

Etant donnée la forme de la cellule photovoltaïque 5 ; 6, le bord périphérique 5C ; 6C présente alors quatre portions 5C1, 5C2, 5C3, 5C4 ; 6C1, 6C2, 6C3, 6C4 permettant de définir la forme rectangulaire ou pseudo-rectangulaire (ou, dans le cas particulier, carrée ou pseudo-carrée). Les portions 5C1, 5C2, 5C3, 5C4 ; 6C1, 6C2, 6C3, 6C4 du bord périphérique 5C ; 6C sont donc parallèles deux à deux.

Les dimensions de la face avant 5A ; 6A et de la face arrière 5B ; 6B sont généralement standardisées, par exemple 156 mm x 156 mm. Dans le cas des sous-cellules (issues du découpage d'une cellule photovoltaïque de pleine taille), ces dimensions sont par exemple de l'ordre de 156 mm x 78 mm.

Les cellules photovoltaïques 5 ; 6 peuvent être des cellules monofaciales ou bifaciales. Dans le cas d'une cellule monofaciale, seule la face avant 5A ; 6A de la cellule photovoltaïque 5 ; 6 capte le rayonnement solaire. Dans le cas d'une cellule bifaciale, les deux faces 5A, 5B ; 6A, 6B de la cellule photovoltaïque 5 ; 6 captent le rayonnement solaire. La face avant 5A ; 6A est alors celle permettant d'obtenir le maximum de courant électrique lorsqu'elle est tournée vers le soleil.

De préférence, les cellules photovoltaïques 5 ; 6 sont prêtes à être interconnectées en une chaîne de cellules. Elles sont munies sur la face avant 5A ; 6A et/ou sur la face arrière 5B ; 6B d'un ou plusieurs éléments de métallisation 7, 8A, 8B, 9A, 9B, 10A, 10B, 11A, 11B, 11C, 12A, 12B, 12C, 13A, 13B, 13C ; 20A, 20B, 22A, 22B (également appelés « métallisations ») destinés à collecter les porteurs de charge photogénérés et à recevoir des éléments d'interconnexion, par exemple des fils ou rubans métalliques.

Les métallisations 7, 8A, 8B, 9A, 9B, 10A, 10B, 11A, 11B, 11C, 12A, 12B, 12C, 13A, 13B, 13C ; 20A, 20B, 22A, 22B sont de préférence ici un réseau d'électrodes 7 (également appelées « doigts de collecte 7 ») et des pistes électriquement conductrices d'interconnexion 8A, 8B, 9A, 9B, 10A, 10B, 11A, 11B, 11C, 12A, 12B, 12C, 13A, 13B, 13C ; 20A, 20B, 22A, 22B appelées « busbars » dans la suite (ces pistes électriquement conductrices d'interconnexion sont également connues sous l'appellation « barres omnibus »). Les busbars 8A, 8B, 9A, 9B, 10A, 10B, 11A, 11B, 11C, 12A, 12B, 12C, 13A, 13B, 13C ; 20A, 20B, 22A, 22B peuvent relier électriquement des doigts de collecte 7 répartis sur toute la superficie de la face avant 5A ; 6A et/ou de la face arrière 5B ; 6B. La face arrière 5B ; 6B des cellules photovoltaïques 5 ; 6 peut aussi être entièrement métallisée.

Les électrodes formant les doigts de collecte 7 sont par exemple déposées sur la face avant 5A ; 6A de la cellule photovoltaïque 5 ; 6. Ces doigts de collecte 7 s'étendent en général parallèlement entre eux le long de la face avant 5A ; 6A de chaque cellule photovoltaïque 5 ; 6. Ils sont ici préférentiellement uniformément répartis sur la face avant 5A ; 6A de chaque cellule photovoltaïque 5 ; 6.

Les doigts de collecte 7 sont étroits, c'est-à-dire qu'ils présentent par exemple une largeur inférieure à 100 micromètres (µm). La largeur est de préférence inférieure à 50 µm. Ils présentent une hauteur de l'ordre de quelques dizaines de micromètres. De préférence, cette hauteur est inférieure à 30 µm. De préférence, cette hauteur est comprise entre 10 et 20 µm.

Ils sont généralement formés par sérigraphie d'une pâte contenant de l'argent, du cuivre ou de l'aluminium. En variante, ils peuvent être formés par dépôt par impression jet d'encre (ou « inkjet ») ou par revêtement métallique (ou « plating » selon le terme d'origine anglosaxonne couramment utilisé).

La face arrière 5B ; 6B de la cellule photovoltaïque 5 ; 6 est soit recouverte d'un autre réseau d'électrodes (cas des cellules bifaciales), soit d'une couche métallique pleine, par exemple en aluminium (cas des cellules monofaciales).

Afin de transporter le courant électrique dans une chaîne photovoltaïque comprenant plusieurs cellules photovoltaïques interconnectées, les doigts de collecte 7 sont reliés entre eux par les busbars 8A, 8B, 9A, 9B, 10A, 10B, 11A, 11B, 11C, 12A, 12B, 12C, 13A, 13B, 13C ; 20A, 20B, 22A, 22B. Ces busbars 8A, 8B, 9A, 9B, 10A, 10B, 11A, 11B, 11C, 12A, 12B, 12C, 13A, 13B, 13C ; 20A, 20B, 22A, 22B sont généralement formés en même temps que les doigts de collecte 7. Les busbars 8A, 8B, 9A, 9B, 10A, 10B, 11A, 11B, 11C, 12A, 12B, 12C, 13A, 13B, 13C ; 20A, 20B, 22A, 22B sont par exemple également formés par sérigraphie d'une pâte contenant de l'argent, du cuivre ou de l'aluminium. En variante, ils peuvent être formés par dépôt par impression jet d'encre (ou « inkjet ») ou par revêtement métallique (ou « plating » selon le terme d'origine anglosaxonne couramment utilisé).

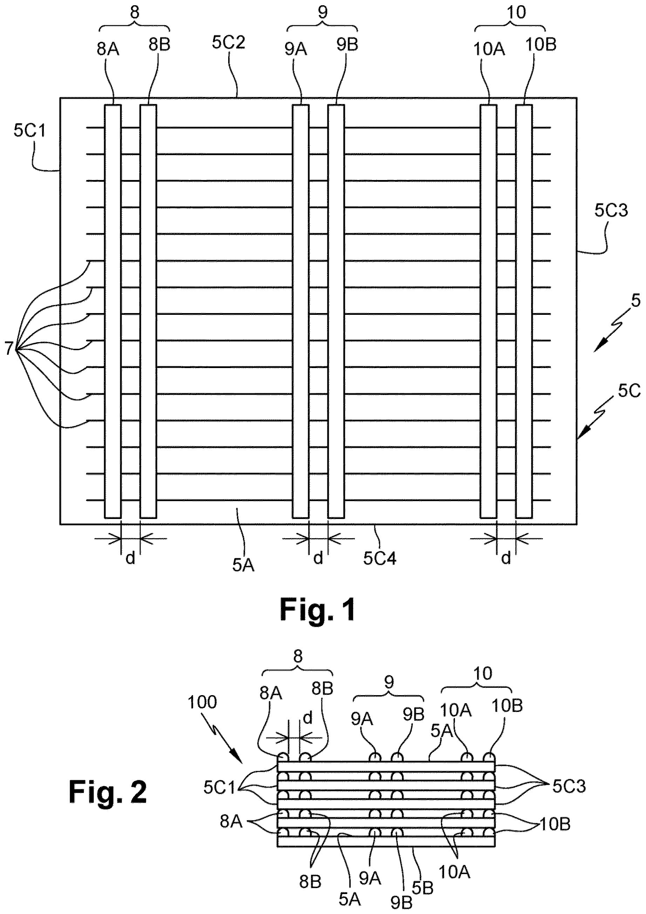

Comme cela est visible par exemple sur la figure 1, les busbars 8A, 8B, 9A, 9B, 10A, 10B relient électriquement les doigts de collecte 7 et sont orientés perpendiculairement aux doigts de collecte 7. Ici, les busbars s'étendent parallèlement à une première portion 5C1 ; 6C1 et une deuxième portion 5C3 ; 6C3 du bord périphérique 5C ; 6C.

La cellule photovoltaïque 5 (de pleine taille) représentée schématiquement sur la figure 1 comprend ici une pluralité de premiers busbars 8A, 9A, 10A et une pluralité de deuxièmes busbars 8B, 9B, 10B formés sur sa face avant 5A, s'étendant perpendiculairement à la pluralité de doigts de collecte 7 représentés. Ici, chacune de la pluralité de premiers busbars 8A, 9A, 10A et de la pluralité de deuxièmes busbars 8B, 9B, 10B comprend trois busbars distincts. De préférence, chacune de la pluralité de premiers busbars 8A, 9A, 10A et de la pluralité de deuxièmes busbars 8B, 9B, 10B comprend entre 6 et 10 busbars.

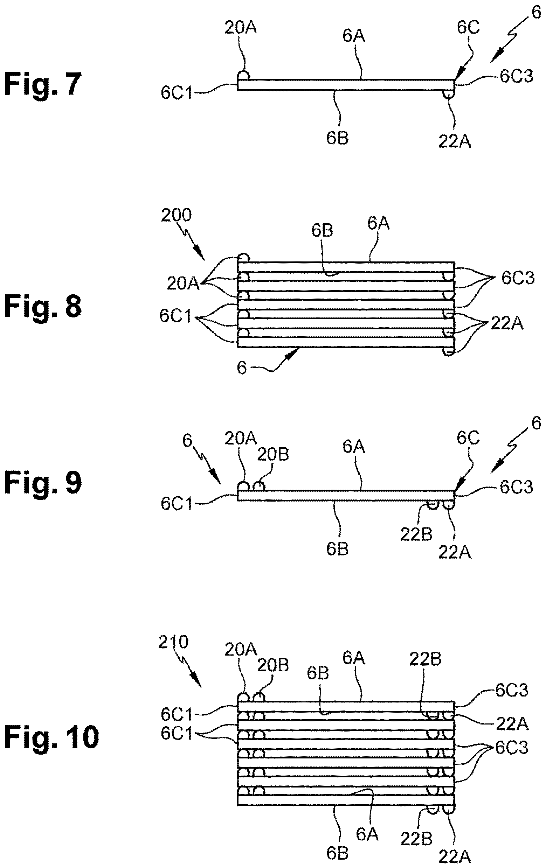

La cellule photovoltaïque 6 représentée sur les figures 7 et 8 correspond à une sous-cellule obtenue par découpage d'une cellule photovoltaïque entière. Dans cet exemple, la sous-cellule 6 est munie d'un premier busbar 20A sur sa face avant 6A et d'un deuxième busbar 22A formé sur sa face arrière 6B.

Chaque busbar 8A, 8B, 9A, 9B, 10A, 10B, 11A, 11B, 11C, 12A, 12B, 12C, 13A, 13B, 13C ; 20A, 20B, 22A, 22B présente une largeur supérieure ou égale à la largeur de chaque doigt de collecte 7. La largeur de chaque busbar est par exemple inférieure à quelques centaines de micromètres, par exemple inférieure à 500 µm. De préférence, la largeur de chaque busbar 8A, 8B, 9A, 9B, 10A, 10B, 11A, 11B, 11C, 12A, 12B, 12C, 13A, 13B, 13C ; 20A, 20B, 22A, 22B est comprise entre 50 et 300 µm.

Chaque busbar 8A, 8B, 9A, 9B, 10A, 10B, 11A, 11B, 11C, 12A, 12B, 12C, 13A, 13B, 13C ; 20A, 20B, 22A, 22B présente une hauteur supérieure ou égale à la hauteur de chaque doigt de collecte 7. La hauteur de chaque busbar 8A, 8B, 9A, 9B, 10A, 10B, 11A, 11B, 11C, 12A, 12B, 12C, 13A, 13B, 13C ; 20A, 20B, 22A, 22B est ici inférieure à 50 µm. De préférence, elle est comprise entre 20 et 30 µm.

Le nombre de busbars formés sur chaque face des cellules photovoltaïques n'est bien entendu pas limité aux exemples présentés sur les figures.

Comme les cellules photovoltaïques 5 ; 6 sont par exemple obtenues par découpage d'une cellule photovoltaïque de pleine taille dont les faces sont munies de couches de passivation, la face avant 5A ; 6A et la face arrière 5B ; 6B de chaque cellule photovoltaïque 5 ; 6 présentent une couche de passivation. Cette couche de passivation rend inactifs les défauts de surface de la cellule photovoltaïque 5 ; 6 et améliore la durée de vie des porteurs de charge photogénérés.

En revanche, le bord périphérique 5C ; 6C de la cellule photovoltaïque 5 ; 6 comprend des zones où le matériau semi-conducteur (i.e. le silicium) a été mis à nu. Autrement dit, ces zones du bord périphérique 5C ; 6C sont dépourvues de couche de passivation (à cause du découpage), à la différence de la face avant 5A ; 6A, de la face arrière 5B ; 6B et des (éventuelles) autres zones du bord périphérique 5C ; 6C de la cellule photovoltaïque 5 ; 6. Par exemple, lorsqu'une cellule photovoltaïque de pleine taille est découpée en quatre bandes de cellule parallèles, deux bandes de cellule présentent deux bords parallèles non passivés, et deux autres bandes de cellule présentent un seul bord non passivé.

Par exemple ici, le découpage est réalisé selon une direction parallèle aux busbars présents sur les cellules photovoltaïques. Les bords mis à nu s'étendent, dans ce cas, parallèlement aux busbars.

Les cellules photovoltaïques 5 concernées peuvent également être des cellules de pleine taille sur lesquelles une partie du bord périphérique 5C a subi une abrasion. Cela est par exemple le cas lorsqu'une ouverture de jonction est mise en oeuvre afin d'éviter d'éventuels courts-circuits. Dans ce cas, le bord périphérique 5C de la cellule photovoltaïque 5 présente également une partie non passivée sur son bord périphérique 5C.

La présente invention vise donc à protéger, par formation d'une couche de passivation, ces zones dans lesquelles le matériau semi-conducteur est mis à nu, tout en protégeant également la surface des busbars (qui vont permettre de réaliser la connexion électrique entre les cellules photovoltaïques).

Pour cela, la présente invention concerne un procédé de passivation des cellules photovoltaïques 5 ; 6 de manière à former une couche de passivation sur une partie de chacune des cellules photovoltaïques 5 ; 6.

Les figures 1 à 6 sont associées à un premier mode de réalisation de ce procédé de passivation conforme à l'invention. Ces figures concernent plusieurs exemples de mise en oeuvre de ce premier mode de réalisation. Ces figures concernent de manière générale les cellules photovoltaïques 5 de pleine taille.

Les figures 7 à 10 sont associées à un deuxième mode de réalisation du procédé de passivation conforme à l'invention. Des exemples de mise en oeuvre de ce deuxième mode de réalisation sont représentés. Ces figures concernent de manière générale les cellules photovoltaïques 6 dites sous-cellules (c'est-à-dire obtenues par découpage d'une cellule photovoltaïque de pleine taille).

Il est à noter que, préalablement à la mise en oeuvre du procédé de passivation (quel que soit le mode de réalisation considéré), les cellules photovoltaïques 5 ; 6 ont été fabriquées à partir de substrats semiconducteurs (par exemple en silicium cristallin). Elles ont également été par exemple découpées ou soumises à une abrasion d'une partie de leur bord périphérique après leur fabrication.

Dans le premier mode de réalisation, chaque cellule photovoltaïque 5 considérée est munie, sur l'une de ses faces 5A, 5B (ici sur la face avant 5A), d'une pluralité de premiers busbars 8A, 9A, 10A et d'une pluralité de deuxièmes busbars 8B, 9B, 10B (comme cela est visible sur les figures 1 et 2).

Comme défini précédemment, les premiers busbars 8A, 9A, 10A s'étendent parallèlement les uns par rapport aux autres et les deuxièmes busbars 8B, 9B, 10B s'étendent parallèlement les uns par rapport aux autres. Ainsi, l'ensemble des busbars de la pluralité de premiers busbars et de la pluralité de deuxièmes busbars s'étendent parallèlement les uns aux autres. Ici, ils s'étendent parallèlement à la première portion 5C1 et à la troisième 5C3 du bord périphérique 5C.

Comme cela est visible sur les figures 1 et 2, une pluralité de couples 8, 9, 10 de busbars sont formés. Chaque couple 8, 9, 10 de busbars comprend un premier busbar 8A, 9A, 10A parmi la pluralité de premiers busbars et un deuxième busbar 8B, 9B, 10B parmi la pluralité de deuxièmes busbars.

En pratique, chaque deuxième busbar 8B, 9B, 10B de la pluralité de deuxièmes busbars est formé à une distance prédéterminée d du premier busbar 8A, 9A, 10A correspondant de la pluralité de premiers busbars. En d'autres termes, dans chaque couple 8, 9, 10 de busbars, le deuxième busbar 8B, 9B, 10B est positionné à distance (et à la même distance) du premier busbar 8A, 9A, 10A.

Avantageusement selon l'invention, la distance prédéterminée est par exemple de l'ordre de la largeur de chaque busbar. De préférence, la distance prédéterminée est inférieure ou égale à 100 µm. De préférence encore, cette distance prédéterminée est inférieure ou égale à 50 µm. En d'autres termes, pour chaque couple 8, 9, 10 de busbars, le deuxième busbar 8B, 9B, 10B est positionné à une distance inférieure ou égale à 100 µm (et de préférence à 50 µm) du premier busbar 8A, 9A, 10A.

Ainsi, chaque cellule photovoltaïque 5 considérée dans le premier mode de réalisation du procédé de passivation comprend, au moins, sur l'une de ses faces 5A, 5B (ici sur la face avant 5A), une pluralité de premiers busbars et une pluralité de deuxièmes busbars. Par rapport à des cellules photovoltaïques classiques, les cellules photovoltaïques 5 selon ce premier mode de réalisation comprennent donc un groupe de busbars supplémentaires (ici la pluralité de deuxièmes busbars) agencés de manière à former des couples de busbars avec les premiers busbars.

Les figures 1 et 2 correspondent à un premier exemple de mise en oeuvre du procédé de passivation.

Ce procédé comprend tout d'abord une première étape de fourniture d'une pluralité de cellules photovoltaïques 5. Lors de cette étape, toutes les cellules photovoltaïques 5 de la pluralité de cellules photovoltaïques considérées présentent la même forme et les mêmes dimensions. Par ailleurs, comme indiqué précédemment, les cellules photovoltaïques 5 de la pluralité de cellules photovoltaïques considérées sont toutes munies, sur l'une de leur face (ici sur la face avant 5A) de la pluralité de premiers busbars 8A, 9A, 10A et de la pluralité de deuxièmes busbars 8B, 9B, 10B.

En pratique, ces cellules photovoltaïques 5 (avec la pluralité de premiers busbars 8A, 9A, 10A et la pluralité de deuxièmes busbars 8B, 9B, 10B) sont par exemple obtenues à partir de cellules photovoltaïques classiques (donc avec seulement la pluralité de premiers busbars par exemple). La pluralité de deuxièmes busbars 8B, 9B, 10B est alors formée en ajoutant la pluralité de deuxième busbars 8B, 9B, 10B sur la face (ici la face avant 5A) comprenant la pluralité de premiers busbars 8A, 9A, 10A. Cela est par exemple mis en oeuvre préalablement à la première étape de fourniture des cellules photovoltaïques 5.

Le procédé de passivation se poursuit alors par une deuxième étape d'empilement de la pluralité de cellules photovoltaïques 5 munies chacune de la pluralité de premiers busbars 8A, 9A, 10A et de la pluralité de deuxièmes busbars 8B, 9B, 10B (un empilement 100, est visible sur la figure 2).

Dans cette description, on entend par « empilement » (ou « stacking » selon le terme d'origine anglosaxonne couramment utilisé) des cellules photovoltaïques, l'agencement de ces cellules photovoltaïques les unes à la suite des autres. L'empilement des cellules photovoltaïques correspond donc à la formation d'un groupe de cellules photovoltaïques.

Cet empilement 100 est par exemple mis en oeuvre verticalement : les cellules photovoltaïques 5 sont alors superposées les unes sur les autres (tel que cela est représenté sur la figure 2). En variante, l'empilement peut être réalisé de manière horizontale. Dans ce cas, les cellules photovoltaïques sont positionnées les unes à la suite des autres.

En pratique, cet empilement est par exemple mis en oeuvre sur un support (non représenté) destiné à être positionné ensuite dans une enceinte de dépôt de couches minces (pour l'étape associée décrite ci-après).

De manière avantageuse selon l'invention, chaque cellule photovoltaïque 5 est positionnée de sorte que la pluralité de premiers busbars 8A, 9A, 10A et la pluralité de deuxièmes busbars 8B, 9B, 10B de la cellule photovoltaïque 5 concernée sont placées entre cette cellule photovoltaïque 5 et la cellule photovoltaïque 5 adjacente. En d'autres termes, dans l'empilement 100, les cellules photovoltaïques 5 sont agencées les unes à la suite des autres avec le positionnement de la pluralité de premiers busbars 8A, 9A, 10A et de la pluralité de deuxièmes busbars 8B, 9B, 10B entre deux cellules photovoltaïques 5 adjacentes.

Cet agencement est mis en oeuvre de telle façon que la face avant 5A de la cellule photovoltaïque 5 munie de la pluralité de premiers busbars 8A, 9A, 10A et de la pluralité de deuxièmes busbars 8B, 9B, 10B est positionnée à distance de la face arrière 5B de la cellule photovoltaïque 5 adjacente. Pour mémoire, les cellules photovoltaïques 5 considérées dans ce premier exemple présentent toutes la même configuration avec la pluralité de premiers busbars 8A, 9A, 10A et la pluralité de deuxièmes busbars 8B, 9B, 10B formés sur leur face avant 5A. Les faces des cellules photovoltaïques 5 ne sont donc pas en contact entre elles lorsque qu'elles sont empilées.

Dans cette étape d'empilement, la pluralité de premiers busbars 8A, 9A, 10A et la pluralité de deuxièmes busbars 8B, 9B, 10B (d'une cellule photovoltaïque 5) sont donc positionnés en contact direct avec la face arrière 5B de la cellule photovoltaïque 5 adjacente.

Cette configuration est particulièrement avantageuse car elle permet d'empiler les cellules photovoltaïques 5 sans que les faces avant et arrière de chaque cellule photovoltaïque 5 ne subissent de contraintes. Cela permet d'éviter des dégradations de performances électriques.

Le procédé de passivation comprend ensuite une étape de dépôt d'une couche de passivation sur une partie des cellules photovoltaïques 5 empilées. Pour cela, l'empilement 100 de cellules photovoltaïques 5 est par exemple placé dans une enceinte de dépôt de couches minces (non représentée sur les figures).

La couche de passivation est formée à partir d'au moins une espèce de passivation. De préférence, cette espèce de passivation se présente sous la forme d'un gaz. Le dépôt de la couche de passivation est alors mis en oeuvre par injection de l'espèce de passivation dans l'enceinte de dépôt mentionnée.

En pratique, une couche de passivation est par exemple formée par dépôt de couches atomiques (ou ALD pour « *Atomic Layer Deposition* » selon l'acronyme d'origine anglo-saxonne couramment utilisé). Selon cette méthode, différents gaz précurseurs sont introduits dans l'enceinte de dépôt de couches minces et acheminés vers les différentes zones (ici les portions du bord périphérique 5C de chaque cellule photovoltaïque 5) sur lesquelles une ou plusieurs couches atomiques doivent être déposées.

En pratique, une couche atomique est formée sur une zone concernée (i.e. ici le bord périphérique 5C de chaque cellule photovoltaïque 5) en exposant cette zone au flux d'un premier gaz précurseur injecté, dans l'enceinte de dépôt de couches minces, par des moyens d'injection (non représentés). Ce premier gaz précurseur réagit avec les terminaisons de la zone concernée et forme une monocouche contenant d'autres terminaisons (groupes réactifs). Un deuxième gaz précurseur (également injecté par les moyens d'injection) introduit ensuite réagit avec les terminaisons de la monocouche formée (à l'issue de l'injection du premier gaz précurseur) de manière à former la couche de passivation souhaitée.

En pratique, les moyens d'injection sont par exemple formés par une tête d'injection (non représentée) permettant l'introduction du gaz dans l'enceinte de dépôt de couches minces. Les conditions de dépôt (telles que la position de la tête d'injection, les débits des gaz, la concentration des précurseurs et la température) et les dimensions de la tête d'injection sont avantageusement choisies de façon à ce que la couche de passivation soit formée par exemple au niveau de la première portion 5C1 et de la deuxième portion 5C3 du bord périphérique 5C de chaque cellule photovoltaïque 5 de l'empilement 100.

De manière préférentielle, le matériau de la couche de passivation est par exemple de l'alumine (Al₂O₃), du dioxyde de silicium (SiO₂), du nitrure de silicium (Si₃N₄) ou du silicium amorphe hydrogéné (a-Siₓ :H).

L'épaisseur de la couche de passivation est de l'ordre de quelques nanomètres (nm) à quelques dizaines de nanomètres. Par exemple, dans le cas de l'alumine, l'épaisseur de la couche de passivation est supérieure à 5 nm, de préférence comprise entre 5 et 15 nm. Dans le cas du silicium amorphe hydrogéné, l'épaisseur de la couche de passivation est de préférence comprise entre 5 et 15 nm.

En variante, l'espèce de passivation peut se présenter sous la forme d'une solution liquide vaporisée. Il s'agit par exemple d'une solution liquide de polymère vaporisée. Le polymère est ici un fluoropolymère tel que le Nafion^{™}.

Grâce à l'agencement décrit précédemment (avec la pluralité de premiers busbars 8A, 9A, 10A et la pluralité de deuxièmes busbars 8B, 9B, 10B sur la face avant 5A de chaque cellule photovoltaïque 5 et empilement des cellules photovoltaïques 5 les unes à la suite des autres avec le positionnement de la pluralité de premiers busbars 8A, 9A, 10A et de la pluralité de deuxièmes busbars 8B, 9B, 10B entre deux cellules photovoltaïques 5 adjacentes), les cellules photovoltaïques 5 sont empilées les unes sur les autres sans contact entre les faces des cellules photovoltaïques entre elles.

De plus, comme le contact entre les cellules photovoltaïques est réalisé au niveau de la surface des premiers et deuxièmes busbars, la surface des busbars n'est pas exposée à l'espèce de passivation. La surface des busbars est donc protégée, ce qui permet d'améliorer l'interconnexion des cellules photovoltaïques lors de la formation du module photovoltaïque.

De plus, grâce à la présence de doubles busbars, la protection des surfaces des métallisations présentes sur les faces des cellules photovoltaïques 5 est renforcée (les espèces de passivation atteignent encore moins la surface des busbars 8A, 9A, 10A, 8B, 9B, 10B, 11A, 12A, 13A, 11B, 12B, 13B présents sur les faces 5A, 5B des cellules photovoltaïques).

L'absence de couche de passivation sur la surface des busbars permet de garantir la qualité de l'interconnexion entre les cellules photovoltaïques. En effet, la colle conductrice permettant l'assemblage des cellules photovoltaïques est directement positionnée sur la surface des busbars. Cela favorise alors le passage des charges électriques entre les cellules photovoltaïques du module photovoltaïque.

Aussi, grâce au positionnement de la pluralité de premiers busbars et de la pluralité de deuxièmes busbars, seules les portions du bord périphérique parallèles aux busbars de chaque cellule photovoltaïque sont visibles et accessibles depuis l'extérieur de l'empilement. En d'autres termes, le long de ces portions du bord périphérique, les busbars (et en particulier les busbars les plus proches de ces portions du bord périphérique) isolent le coeur de chaque cellule photovoltaïque de l'extérieur de l'empilement. Cela permet alors de s'assurer que, le long de ces portions, seul le bord périphérique des cellules photovoltaïques et une faible surface des faces avant et arrière (au niveau des portions du bord périphérique transversales aux busbars) est exposé aux espèces de passivation pour le dépôt de la couche de passivation.

De plus, la présence des couples de busbars (notamment à proximité des portions du bord périphérique) permet de renforcer cet effet de barrière de pénétration aux espèces de passivation.

En variante, le dépôt de la couche de passivation peut être réalisé par d'autres méthodes. Par exemple, des méthodes de dépôt physique par phase vapeur (ou PVD pour « *Physical Vapor Deposition »* selon l'acronyme d'origine anglo-saxonne) ou de dépôt chimique en phase vapeur (ou CVD pour « *Chemical Vapor Deposition* ») peuvent être utilisées.

En variante encore, une méthode chimique de dépôt en phase liquide peut être utilisée.

En variante encore, des méthodes de dépôt sur la base de plasma peuvent également être utilisés. Dans un tel cas, les matériaux utilisés, en particulier pour les parties de support, doivent être adaptés pour être conducteurs. Pour cela, il est notamment possible d'utiliser du graphite.

En pratique, les deux cellules photovoltaïques d'extrémité de l'empilement ne sont pas utilisées par la suite car elles sont soit en contact direct avec le support pour le dépôt de la couche de passivation, soit soumise à la formation de la couche de passivation sur l'ensemble de l'une de ses faces. Ces deux cellules photovoltaïques sont en quelque sorte sacrifiées dans le processus de passivation.

Par ailleurs, il est à noter qu'il est possible que, le long des portions 5C2, 5C4 du bord périphérique 5C, une couche de passivation puisse tout de même être formée sur une partie des faces avant et arrière de chaque cellule photovoltaïque. Toutefois, étant donné l'agencement des cellules photovoltaïques en empilement, la largeur de la couche formée reste faible (inférieure à 100 µm le long des portions 5C2, 5C4 du bord périphérique 5C).

Selon une variante non représentée, seuls les busbars d'extrémité peuvent présenter une configuration double. En d'autres termes, dans cette variante et par exemple en lien avec la figure 1, la pluralité de deuxièmes busbars comprend uniquement deux busbars (les deuxièmes busbars 8B, 10B) positionnés à proximité des portions 5C1, 5C3 du bord périphérique de la cellule photovoltaïque.

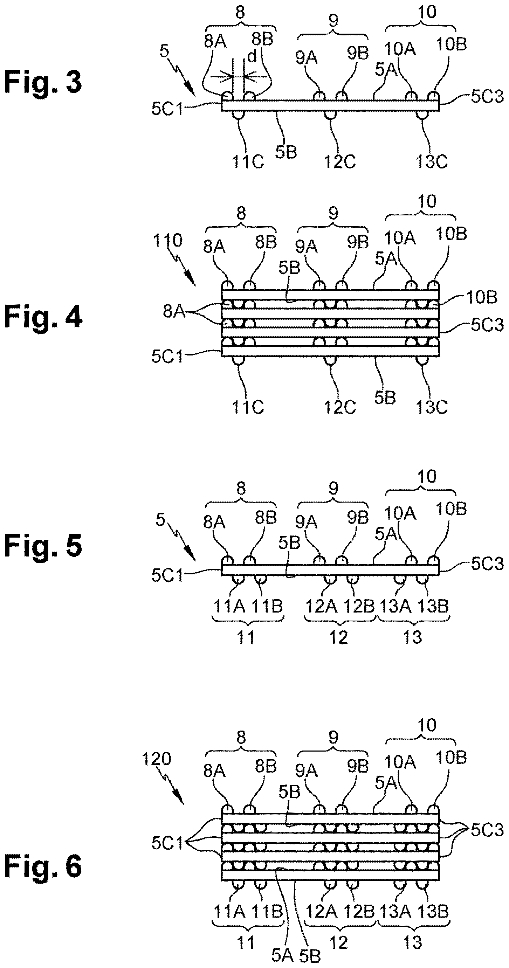

Les figures 3 et 4 correspondent à un deuxième exemple de mise en oeuvre du procédé de passivation conforme à l'invention.

Le procédé de passivation selon ce deuxième exemple comprend les mêmes étapes de fourniture de la pluralité de cellules photovoltaïques, d'empilement et de dépôt d'une couche de passivation que le premier exemple de mise en oeuvre. Ainsi, seules les différences par rapport à ce premier exemple sont décrites en détails dans la suite.

Dans ce deuxième exemple, chaque cellule photovoltaïque 5 est munie sur l'une de ses faces de la pluralité de premiers busbars 8A, 9A, 10A et de la pluralité de deuxièmes busbars 8B, 9B, 10B et sur l'autre de ses faces d'une pluralité de troisièmes busbars 11C, 12C, 13C.

Comme le montrent les figures 3 et 4, la pluralité de premiers busbars 8A, 9A, 10A et la pluralité de deuxièmes busbars 8B, 9B, 10B sont formées sur la face avant 5A de la cellule photovoltaïque 5. La pluralité de troisièmes busbars est, quant à elle, formée sur la face opposée, c'est-à-dire sur la face arrière 5B de la cellule photovoltaïque 5.

En d'autres termes, dans ce deuxième exemple, la cellule photovoltaïque 5 est munie, sur l'une de ses faces de couples de busbars 8, 9, 10 (comme dans le premier exemple décrit précédemment) et, sur l'autre de ses faces, d'une seule série de troisièmes busbars 11C, 12C, 13C.

La spécificité de ce deuxième exemple réside sur le positionnement de chaque troisième busbar 11C, 12C, 13C (sur la face arrière 5B de la cellule photovoltaïque 5) par rapport à chaque couple 8, 9, 10 de busbars formés sur la face avant 5A de la cellule photovoltaïque 5.

Comme décrit dans le premier exemple, dans chaque couple 8, 9, 10 de busbars, le premier busbar 8A, 9A, 10A et le deuxième busbar 8B, 9B, 10B sont formés à distance l'un de l'autre. Un espace est donc défini entre le premier busbar 8A, 9A, 10A et le deuxième busbar 8B, 9B, 10B de chaque couple 8, 9, 10 de busbars.

Dans ce deuxième exemple, de manière avantageuse, chaque troisième busbar 11C, 12C, 13C de la pluralité de troisièmes busbars est positionné en regard de l'espace défini entre le premier busbar 8A, 9A, 10A et le deuxième busbar 8B, 9B, 10B du couple 8, 9, 10 de busbars concerné. Ce positionnement permet alors, lors de l'étape d'empilement décrite ci-après, de positionner chaque troisième busbar 11C, 12C, 13C de la pluralité de troisièmes busbars d'une cellule photovoltaïque 5 entre le premier busbar 8A, 9A, 10A et le deuxième busbar 8B, 9B, 10B du couple 8, 9, 10 de busbars concerné d'une cellule photovoltaïque adjacente.

Comme décrit précédemment, de manière avantageuse selon l'invention, la distance prédéterminée est par exemple de l'ordre de la largeur de chaque busbar. De préférence, cette distance prédéterminée est inférieure ou égale à 100 µm. De préférence encore, cette distance prédéterminée est inférieure ou égale à 50 µm. En d'autres termes, pour chaque couple 8, 9, 10 de busbars, le deuxième busbar 8B, 9B, 10B est positionné à une distance inférieure ou égale à 100 µm (et de préférence à 50 µm) du premier busbar 8A, 9A, 10A associé.

Ainsi, dans ce deuxième exemple (figures 3 et 4), avant l'étape d'empilement, chaque cellule photovoltaïque 5 de la pluralité de cellules photovoltaïques est munie, d'une part, de la pluralité de premiers busbars 8A, 9A, 10A et de la pluralité de deuxièmes busbars 8B, 9B, 10B sur l'une de ses faces (ici la face avant 5A) et, d'autre part, de la pluralité de troisièmes busbars 11C, 12C, 13C sur l'autre de ses faces (ici la face arrière 5B).

Le procédé de passivation se poursuit alors par l'étape d'empilement de la pluralité de cellules photovoltaïques 5 munies chacune, sur leur face avant, de la pluralité de premiers busbars 8A, 9A, 10A et de la pluralité de deuxièmes busbars 8B, 9B, 10B, et, sur leur face arrière 5B, de la pluralité de troisièmes busbars 11C, 12C, 13C. L'empilement 110 est alors formé (visible sur la figure 4).

Cet empilement 110 est ici mis en oeuvre verticalement : les cellules photovoltaïques 5 sont alors superposées les unes sur les autres (tel que cela est représenté sur la figure 4). En variante, l'empilement peut être réalisé de manière horizontale. Dans ce cas, les cellules photovoltaïques sont positionnées les unes à la suite des autres.

De manière avantageuse selon l'invention, chaque cellule photovoltaïque 5 est positionnée de sorte que, d'une part, la pluralité de premiers busbars 8A, 9A, 10A et la pluralité de deuxièmes busbars 8B, 9B, 10B d'une cellule photovoltaïque et, d'autre part, la pluralité de troisièmes busbars 11C, 12C, 13C de la cellule photovoltaïque 5 adjacente sont placées entre cette cellule photovoltaïque 5 et la cellule photovoltaïque 5 adjacente. En d'autres termes, dans l'empilement 110, les cellules photovoltaïques 5 sont agencées les unes à la suite des autres avec le positionnement de la pluralité de premiers busbars 8A, 9A, 10A et de la pluralité de deuxièmes busbars 8B, 9B, 10B d'une cellule photovoltaïque 5 et de la pluralité de troisièmes busbars 11C, 12C, 13C d'une cellule photovoltaïque adjacente entre deux cellules photovoltaïques 5 adjacentes.

Autrement dit encore, cet agencement est mis en oeuvre de telle façon que la face avant 5A de la cellule photovoltaïque 5 munie de la pluralité de premiers busbars 8A, 9A, 10A et de la pluralité de deuxièmes busbars 8B, 9B, 10B est positionnée à distance de la face arrière 5B de la cellule photovoltaïque 5 adjacente munie de la pluralité de troisièmes busbars 11C, 12C, 13C. Pour mémoire, les cellules photovoltaïques 5 considérées dans ce deuxième exemple présentent toutes la même configuration avec la pluralité de premiers busbars 8A, 9A, 10A et la pluralité de deuxièmes busbars 8B, 9B, 10B formées sur la face avant 5A et la pluralité de troisièmes busbars 11C, 12C, 13C formée sur la face arrière 5B. Les faces des cellules photovoltaïques 5 ne sont donc pas en contact entre elles lorsque qu'elles sont empilées. Cela permet notamment d'éviter de dégrader les zones métalliques d'interconnexion, et donc les performances électriques des cellules photovoltaïques.

De manière avantageuse ici, et grâce à l'agencement de la pluralité de premiers busbars 8A, 9A, 10A, de la pluralité de deuxièmes busbars 8B, 9B, 10B et de la pluralité de troisièmes busbars 11C, 12C, 13C, l'empilement des cellules photovoltaïques 5 est mis en oeuvre de telle façon que chaque troisième busbar 11C, 12C, 13C de la pluralité de troisièmes busbars d'une cellule photovoltaïque 5 est positionné entre le premier busbar 8A, 9A, 10A et le deuxième busbar 8B, 9B, 10B du couple 8, 9, 10 de busbars concerné d'une cellule photovoltaïque adjacente. Cette configuration est visible sur la figure 4.

En plus des avantages présentés pour le premier exemple décrit précédemment, la configuration du deuxième exemple est particulièrement avantageuse car, grâce à l'agencement, en alternance et de manière juxtaposée, d'un couple de busbars 8, 9, 10 concerné et d'un troisième busbar 11C, 12C, 13C correspondant, elle permet de renforcer la protection des surfaces des métallisations présentes sur les faces des cellules photovoltaïques 5 (les espèces de passivation atteignent encore moins la surface des busbars 8A, 9A, 10A, 8B, 9B, 10B, 11C, 12C, 13C présents sur les faces 5A, 5B des cellules photovoltaïques).

De plus, cette configuration (en alternance et juxtaposition) permet également de renforcer l'effet de barrière à la pénétration des espèces de passivation utilisées pour le dépôt. En effet, le long de chaque portion 5C1, 5C3 du bord périphérique 5C, les trois busbars juxtaposés forment donc une triple barrière pour la pénétration des espèces de passivation utilisées pour le dépôt. Cela permet de s'assurer, d'autant plus, que, le long de la première portion 5C1 et de la deuxième portion 5C3 du bord périphérique, seul le bord périphérique 5C des cellules photovoltaïques 5 est exposé aux espèces de passivation pour le dépôt de la couche de passivation.

Par ailleurs, le positionnement de chaque troisième busbar 11C, 12C, 13C entre le premier busbar 8A, 9A, 10A et le deuxième busbar 8B, 9B, 10B de chaque couple 8, 9, 10 de busbars permet de garantir un bon alignement des cellules photovoltaïques 5 lors de leur empilement.

Les figures 5 et 6 correspondent à un troisième exemple de mise en oeuvre du procédé de passivation selon le premier mode de réalisation de l'invention.

Le procédé de passivation selon ce troisième exemple comprend les mêmes étapes de fourniture, d'empilement et de dépôt d'une couche de passivation que le premier mode de réalisation décrit précédemment. Aussi, seules les différences par rapport à ce premier exemple de réalisation sont décrites en détails dans la suite.

Ainsi, sur la base de ce qui est décrit pour le premier exemple décrit précédemment, l'une des faces (par exemple la face avant) de chaque cellule photovoltaïque 5 est munie de la pluralité de premiers busbars 8A, 9A, 10A et de la pluralité de deuxièmes busbars 8B, 9B, 10B.

Dans ce troisième exemple de mise en oeuvre, chaque cellule photovoltaïque 5 est également munie, sur son autre face (ici sur la face arrière 5B), d'une pluralité de quatrième busbars 11A, 12A, 13A et d'une pluralité de cinquièmes busbars 11B, 12B, 13B.

De la même façon que ce qui est décrit précédemment, les quatrièmes busbars 11A, 12A, 13A s'étendent parallèlement les uns aux autres et les cinquièmes busbars 11B, 12B, 13B s'étendent parallèlement les uns aux autres. Ainsi, l'ensemble des busbars de la pluralité de quatrièmes busbars et de la pluralité de cinquièmes busbars s'étendent parallèlement les uns aux autres. Ici, ils s'étendent parallèlement à la première portion 5C1 et à la troisième portion 5C3 du bord périphérique 5C.

Ainsi, une pluralité d'autres couples 11, 12, 13 de busbars sont formés. Chaque autre couple 11, 12, 13 de busbars comprend un quatrième busbar 11A, 12A, 13A parmi la pluralité de quatrièmes busbars et un cinquième busbar 11B, 12B, 13B parmi la pluralité de cinquièmes busbars.

En pratique, chaque cinquième busbar 11B, 12B, 13B de la pluralité de cinquièmes busbars est formé à une distance prédéterminée d du quatrième busbar 11A, 12A, 13A correspondant de la pluralité de quatrièmes busbars. En d'autres termes, dans chaque autre couple 11, 12, 13 de busbars, le cinquième busbar 11B, 12B, 13B est positionné à distance (et à la même distance) du quatrième busbar 11A, 12A, 13A correspondant.

Avantageusement selon l'invention, la distance prédéterminée est par exemple de l'ordre de la largeur de chaque busbar. De préférence, la distance prédéterminée est inférieure ou égale à 100 µm. De préférence encore, cette distance prédéterminée est inférieure ou égale à 50 µm. En d'autres termes, pour chaque couple 11, 12, 13 de busbars, le cinquième busbar 11B, 12B, 13B est positionné à une distance inférieure ou égale à 100 µm (et de préférence à 50 µm) du quatrième busbar 11A, 12A, 13A.

En d'autres termes, dans ce troisième exemple, la cellule photovoltaïque 5 est munie, sur l'une de ses faces (ici la face avant 5A) d'une pluralité de couples 8, 9, 10 de busbars et, sur l'autre de ses faces (ici la face arrière 5B) d'une pluralité d'autres couples 11, 12, 13 de busbars.

La spécificité de ce troisième exemple réside sur le positionnement de chaque autre couple 11, 12, 13 de busbars par rapport au couple 8, 9, 10 correspondant.

Comme décrit dans le premier exemple, dans chaque couple 8, 9, 10 de busbars, le premier busbar 8A, 9A, 10A et le deuxième busbar 8B, 9B, 10B sont formés à distance l'un de l'autre. Un espace est donc défini entre le premier busbar 8A, 9A, 10A et le deuxième busbar 8B, 9B, 10B de chaque couple 8, 9, 10 de busbars.

Dans ce troisième exemple, de manière avantageuse, le quatrième busbar 11A, 12A, 13A de chaque autre couple 11, 12, 13 de busbars est positionné en regard de l'espace défini entre le premier busbar 8A, 9A, 10A et le deuxième busbar 8B, 9B, 10B du couple 8, 9, 10 de busbars correspondant.

De manière similaire, dans chaque autre couple 11, 12, 13 de busbars, le quatrième busbar 11A, 12A, 13A et le cinquième busbar 11B, 12B, 13B sont formés à distance l'un de l'autre. Un espace est donc défini entre le quatrième busbar 11A, 12A, 13A et le cinquième busbar 11B, 12B, 13B de chaque autre couple 11, 12, 13 de busbars. Dans ce troisième exemple, le deuxième busbar 8B, 9B, 10B de chaque couple 8, 9, 10 de busbars est donc positionné en regard de l'espace défini entre le quatrième busbar 11A, 12A, 13A et le cinquième busbar 11B, 12B, 13B de l'autre couple 11, 12, 13 de busbars correspondant.

Cette configuration permet alors, lors de l'étape d'empilement décrite ci-après, de positionner le quatrième busbar de chaque autre couple 11, 12, 13 de busbars d'une cellule photovoltaïque 5 entre le premier busbar 8A, 9A, 10A et le deuxième busbar 8B, 9B, 10B du couple 8, 9, 10 de busbars correspondant d'une cellule photovoltaïque 5 adjacente.

En d'autres termes, comme visible sur la figure 6, il y a un décalage de positionnement entre le premier busbar 8A, 9A, 10A et le deuxième busbar 8B, 9B, 10B de chaque couple 8, 9, 10 de busbars (sur la face avant) et le quatrième busbar 11A, 12A, 13A et le cinquième busbar 11B, 12B, 13B de chaque autre couple 11, 12, 13 de busbars correspondant (sur la face arrière).

La distance entre le quatrième busbar 11A, 12A, 13A et le cinquième busbar 11B, 12B, 13B de chaque autre couple 11, 12, 13 de busbars (sur la face arrière 5B) est par exemple identique à la distance entre le premier busbar 8A, 9A, 10A et le deuxième busbar 8B, 9B, 10B de chaque couple 8, 9, 10 de busbars correspondant (sur la face avant 5A de la cellule photovoltaïque 5). En variante, elle peut bien entendu être différente.

Le procédé de passivation se poursuit alors par l'étape d'empilement de la pluralité de cellules photovoltaïques 5 munies chacune, sur leur face avant, de la pluralité de premiers busbars 8A, 9A, 10A et de la pluralité de deuxièmes busbars 8B, 9B, 10B, et, sur leur face arrière 5B, de la pluralité de quatrièmes busbars 11A, 12A, 13A et de la pluralité de cinquièmes busbars 11B, 12B, 13B. L'empilement 120 est alors formé (visible sur la figure 6).

Cet empilement 120 est ici mis en oeuvre verticalement : les cellules photovoltaïques 5 sont alors superposées les unes sur les autres (tel que cela est représenté sur la figure 6). En variante, l'empilement peut être réalisé de manière horizontale. Dans ce cas, les cellules photovoltaïques sont positionnées les unes à la suite des autres.

De manière avantageuse selon l'invention, chaque cellule photovoltaïque 5 est positionnée de sorte que, d'une part, la pluralité de premiers busbars 8A, 9A, 10A et la pluralité de deuxièmes busbars 8B, 9B, 10B de la face avant 5A d'une cellule photovoltaïque 5 et, d'autre part, la pluralité de quatrièmes busbars 11A, 12A, 13A et la pluralité de cinquièmes busbars 11B, 12B, 13B de la face arrière 5B de la cellule photovoltaïque 5 adjacente sont placés entre cette cellule photovoltaïque 5 et la cellule photovoltaïque 5 adjacente. En d'autres termes, dans l'empilement 120, les cellules photovoltaïques 5 sont agencées les unes à la suite des autres avec le positionnement de la pluralité de premiers busbars 8A, 9A, 10A et de la pluralité de deuxièmes busbars 8B, 9B, 10B de la face avant 5A d'une cellule photovoltaïque 5 et de la pluralité de quatrièmes busbars 11A, 12A, 13A et de la pluralité de cinquièmes busbars 11B, 12B, 13B de la face arrière 5B d'une cellule photovoltaïque adjacente entre ces deux cellules photovoltaïques 5 adjacentes.

Autrement dit encore, cet agencement est mis en oeuvre de telle façon que la face avant 5A de la cellule photovoltaïque 5 munie de la pluralité de premiers busbars 8A, 9A, 10A et de la pluralité de deuxièmes busbars 8B, 9B, 10B est positionnée à distance de la face arrière 5B de la cellule photovoltaïque 5 adjacente munie de la pluralité de quatrièmes busbars 11A, 12A, 13A et de la pluralité de cinquièmes busbars 11B, 12B, 13B. Pour mémoire, les cellules photovoltaïques 5 considérées dans ce cinquième exemple présentent toutes la même configuration avec la pluralité de premiers busbars 8A, 9A, 10A et la pluralité de deuxièmes busbars 8B, 9B, 10B formées sur la face avant 5A et la pluralité de quatrièmes busbars 11A, 12A, 13A et la pluralité de cinquièmes busbars 11B, 12B, 13B formées sur la face arrière 5B. Les faces des cellules photovoltaïques 5 ne sont donc pas en contact entre elles lorsque qu'elles sont empilées. Cela permet notamment d'éviter de dégrader les zones métalliques d'interconnexion, et donc les performances électriques des cellules photovoltaïques.

De manière avantageuse ici, et grâce à l'agencement, d'une part, de la pluralité de premiers busbars 8A, 9A, 10A, de la pluralité de deuxièmes busbars 8B, 9B, 10B sur la face avant 5A et, d'autre part, de la pluralité de quatrièmes busbars 11A, 12A, 13A et de la pluralité de cinquièmes busbars 11B, 12B, 13B sur la face arrière 5B, l'empilement des cellules photovoltaïques 5 est mis en oeuvre de telle façon que chaque quatrième busbar 11A, 12A, 13A de la pluralité des quatrièmes busbars d'une cellule photovoltaïque 5 est positionné entre le premier busbar 8A, 9A, 10A et le deuxième busbar 8B, 9B, 10B du couple 8, 9, 10 de busbars concerné d'une cellule photovoltaïque 5 adjacente. Cet agencement entraîne alors que chaque deuxième busbar 8B, 9B, 10B de la pluralité de deuxièmes busbars d'une cellule photovoltaïque 5 est positionné entre le quatrième busbar 11A, 12A, 13A et le cinquième busbar 11B, 12B, 13B du couple 11, 12, 13 de busbars concerné d'une cellule photovoltaïque adjacente. Cette configuration est visible sur la figure 6.

En plus des avantages présentés pour le premier exemple décrit précédemment, la configuration du troisième exemple est particulièrement avantageuse car, grâce à l'agencement, en alternance et de manière juxtaposée, des busbars des couples 8, 9, 10 de busbars et des autres couples 11, 12, 13 de busbars, elle permet de renforcer la protection des surfaces des métallisations présentes sur les faces des cellules photovoltaïques 5 (les espèces de passivation atteignent encore moins la surface des busbars 8A, 9A, 10A, 8B, 9B, 10B, 11A, 12A, 13A, 11B, 12B, 13B présents sur les faces 5A, 5B des cellules photovoltaïques).

De plus, cette configuration (en alternance et juxtaposition) permet également de renforcer l'effet de barrière à la pénétration des espèces de passivation utilisées pour le dépôt. Le long de chaque portion 5C1, 5C3 du bord périphérique 5C, les quatre busbars juxtaposés forment donc une quadruple barrière pour la pénétration des espèces de passivation utilisées pour le dépôt. Cela permet de s'assurer, d'autant plus, que, le long de la première portion 5C1 et de la deuxième portion 5C3 du bord périphérique, seul le bord périphérique 5C des cellules photovoltaïques 5 est exposé aux espèces de passivation pour le dépôt de la couche de passivation.

Par ailleurs, le positionnement de chaque quatrième busbar 11A, 12A, 13A entre le premier busbar 8A, 9A, 10A et le deuxième busbar 8B, 9B, 10B de chaque couple 8, 9, 10 de busbars permet de garantir un bon alignement des cellules photovoltaïques 5 lors de leur empilement.

Les figures 7 à 10 concernent un deuxième mode de réalisation du procédé de passivation conforme à l'invention. Ce deuxième mode de réalisation trouve une application particulièrement avantageuse pour les sous-cellules de superficie plus faible (selon le format communément appelé « shingle »).

Dans ce deuxième mode de réalisation, chaque cellule photovoltaïque 6 considérée est munie, sur l'une de ses faces, d'au moins un premier busbar 20A, et, sur l'autre de ses faces, d'un deuxième busbar 22A.

Comme cela est représenté sur la figure 7, le premier busbar 20A s'étend parallèlement à la première portion 6C1 du bord périphérique 6C de la cellule photovoltaïque 6. Le premier busbar 20A est ici positionné sur la face avant 6A de la cellule photovoltaïque 6.

Le deuxième busbar 22A s'étend parallèlement à la deuxième portion 6C3 du bord périphérique 6C. Le deuxième busbar 22A est placé sur la face opposée à celle munie du premier busbar 20A. Ici, le deuxième busbar 22A est donc positionné sur la face arrière 6B de la cellule photovoltaïque 6.

Ici, de par le processus de fabrication de la cellule photovoltaïque 6, le premier busbar 20A et le deuxième busbar 22A sont, chacun, formés (ici chacun sur une face 6A, 6B de la cellule photovoltaïque 6) à proximité du bord périphérique 6C.

Ainsi, chaque cellule photovoltaïque 6 considérée dans le deuxième mode de réalisation du procédé de passivation comprend, au moins, sur l'une de ses faces 6A, 6B, le premier busbar 20A positionné à proximité de la première portion 6C1 du bord périphérique 6C et, sur la face opposée 6A, 6B, le deuxième busbar 22A positionné à proximité de la deuxième portion 6C3 du bord périphérique 6C.

Les figures 7 et 8 correspondent à un premier exemple de mise en oeuvre du procédé de passivation selon le deuxième mode de réalisation.

Le procédé de passivation selon ce premier exemple du deuxième mode de réalisation comprend les mêmes étapes de fourniture de la pluralité de cellules photovoltaïques, d'empilement et de dépôt d'une couche de passivation que le premier exemple de mise en oeuvre du premier mode de réalisation décrit précédemment. Aussi, seules les différences par rapport à ce premier exemple du premier mode de réalisation sont décrites en détails dans la suite.

Dans ce premier exemple de mise en oeuvre du deuxième mode de réalisation, toutes les cellules photovoltaïques 6 de la pluralité de cellules photovoltaïques sont chacune munies, sur l'une de leurs faces, du premier busbar 20A (ici sur la face avant 6A) et, sur la face opposée (ici la face arrière 6B), du deuxième busbar 22A.

En pratique, ces cellules photovoltaïques 6 (avec le premier busbar 20A sur la face avant 6A et le deuxième busbar 22A sur la face arrière 6B) sont par exemple obtenues suite au découpage de cellules photovoltaïques classiques de pleine taille. Le découpage s'effectue de telle manière que chaque sous-cellule obtenue comprend généralement un seul busbar (par exemple ici le premier busbar 20A sur la face avant).

Chaque cellule photovoltaïque 6 est ensuite obtenue par formation du deuxième busbar 22A sur la face opposée à la face comprenant le premier busbar 20A (ici la face arrière 6A). En d'autres termes, chaque cellule photovoltaïque 6 est donc obtenue en ajoutant un busbar supplémentaire (ici le deuxième busbar 22A) sur la face opposée à la face de la sous-cellule (obtenue par le découpage) sur laquelle se trouve le premier busbar 20A. Cela est par exemple mis en oeuvre préalablement à la première étape de fourniture des cellules photovoltaïques 6.

Le procédé de passivation comprend alors l'étape d'empilement de la pluralité des cellules photovoltaïques 6, munies de leur premier busbar 20A sur la face avant 6A et de leur deuxième busbar 22A sur la face arrière 6B. Un empilement 200 est représenté sur la figure 8.

Cet empilement 200 est par exemple mis en oeuvre verticalement : les cellules photovoltaïques 6 sont alors superposées les unes sur les autres (tel que cela est représenté sur la figure 8). En variante, l'empilement peut être réalisé de manière horizontale. Dans ce cas, les cellules photovoltaïques sont positionnées les unes à la suite des autres.

De manière avantageuse selon l'invention, chaque cellule photovoltaïque 6 est positionnée de sorte que le premier busbar 20A de la cellule photovoltaïque 6 concernée et le deuxième busbar 22A de la cellule photovoltaïque 6 adjacente sont placés entre cette cellule photovoltaïque 6 et la cellule photovoltaïque 6 adjacente. En d'autres termes, dans l'empilement 200, les cellules photovoltaïques 6 sont agencées les unes à la suite des autres avec le positionnement du premier busbar 20A d'une cellule photovoltaïque et le positionnement du deuxième busbar 22A de la cellule photovoltaïque adjacente entre ces cellules photovoltaïques 6. Cet agencement est mis en oeuvre de telle façon que la face avant 6A de la cellule photovoltaïque 6 munie du premier busbar 20A est positionnée à distance de la face arrière 6B de la cellule photovoltaïque 6 adjacente munie du deuxième busbar 22B. Les faces des cellules photovoltaïques 6 ne sont donc pas en contact entre elles lorsque qu'elles sont empilées.

Dans cette étape d'empilement, le premier busbar 20A de la cellule photovoltaïque concernée et le deuxième busbar 22B de la cellule photovoltaïque adjacente sont donc positionnés en contact direct avec la face opposée de la cellule photovoltaïque 6 en regard. En d'autres termes, en considérant une première cellule photovoltaïque et une deuxième cellule photovoltaïque, le premier busbar de la première cellule photovoltaïque est en contact direct avec la face arrière de la deuxième cellule photovoltaïque et le deuxième busbar de la deuxième cellule photovoltaïque est en contact direct avec la face avant de la première cellule photovoltaïque.

En pratique, cette étape d'empilement comprend par exemple une étape de rotation de la cellule photovoltaïque 6 à empiler de manière à assurer le contact direct entre le premier busbar 20A de la cellule photovoltaïque concernée et le deuxième busbar 22B de la cellule photovoltaïque adjacente. En d'autres termes, les cellules photovoltaïques 6 sont ici empilées sans contact direct entre le premier busbar 20A d'une cellule photovoltaïque et le deuxième busbar 22A de la cellule photovoltaïque adjacente.

La rotation réalisée est par exemple ici une rotation d'un angle de 180 degrés.

Cette configuration est particulièrement avantageuse car elle permet d'empiler les cellules photovoltaïques 6 sans que les faces avant et arrière de chaque cellule photovoltaïque 6 ne subissent de contraintes, ni que les métallisations soient au contact entre elles. Cela permet alors d'éviter des dégradations de performances électriques.

De plus, grâce à la présence du premier busbar 20A et du deuxième busbar 22A et à leur positionnement par rapport au bord périphérique 6C, lorsque les cellules photovoltaïques 6 sont empilées, seul le bord périphérique 6C (le long de la première portion 6C1 et de la deuxième portion 6C3 du bord périphérique 6C) de chaque cellule photovoltaïque 6 est visible et accessible depuis l'extérieur de l'empilement 200. En d'autres termes, le premier busbar 20A et le deuxième busbar 22A isolent, le long de la première portion 6C1 et de la deuxième portion 6C3 du bord périphérique 6C, le coeur de chaque cellule photovoltaïque 6 de l'extérieur de l'empilement 200. Cela permet alors de s'assurer que, le long de la première portion 6C1 et de la deuxième portion 6C3 du bord périphérique, seul le bord périphérique 6C des cellules photovoltaïques 6 est exposé aux espèces de passivation pour le dépôt de la couche de passivation (comme indiqué précédemment, ce dépôt de la couche de passivation est effectué de la manière décrite dans le premier exemple de mise en oeuvre du premier mode de réalisation).

En variante de ce premier exemple, avant l'étape d'empilement, il peut être prévu une étape de formation, sur chaque cellule photovoltaïque, d'un élément de protection sur chacune des faces avant et arrière. Cet élément de protection présente par exemple les mêmes formes et dimensions qu'un busbar et est formé sur chacune des faces avant et arrière, le long de la portion du bord périphérique ne présentant pas de busbars.

Autrement dit, ici, un premier élément de protection est par exemple formé, sur la face avant de chaque cellule photovoltaïque, en regard du deuxième busbar présent sur la face arrière et un deuxième élément de protection est formé sur la face arrière, en regard du premier busbar présent sur la face avant.

L'élément de protection est par exemple formé d'un matériau métallique conducteur électriquement. Il s'agit par exemple d'aluminium.

Lors de l'empilement des cellules photovoltaïques, le premier busbar et le deuxième busbar ne sont plus en contact direct avec la face en regard de la cellule adjacente mais avec l'élément de protection formé sur la face en regard. Cela permet alors d'éviter le contact direct avec la face concernée de la cellule photovoltaïque, et donc d'éviter de dégrader les performances électriques de la cellule (car dans le cas des sous-cellules, les extrémités des faces avant et arrière, sans busbars, sont potentiellement munies de zones métalliques d'interconnexion).

Les figures 9 et 10 correspondent à un deuxième exemple de mise en oeuvre du procédé de passivation selon le deuxième mode de réalisation.

Le procédé de passivation selon ce deuxième exemple comprend les mêmes étapes de fourniture de la pluralité de cellules photovoltaïques, d'empilement et de dépôt d'une couche de passivation que le premier exemple de mise en oeuvre. Aussi, seules les différences par rapport à ce premier exemple sont décrites en détails dans la suite.

Dans ce deuxième exemple de mise en oeuvre, chaque cellule photovoltaïque 6 comprend également un troisième busbar 20B et un quatrième busbar 22B. Le troisième busbar 20B est formé sur la même face que celle munie du premier busbar 20A. Le quatrième busbar 22B est formé sur la même face que celle munie du deuxième busbar 22B. En d'autres termes, comme cela est visible sur la figure 9, la face avant 6A de chaque cellule photovoltaïque 6 est ici munie du premier busbar 20A et du troisième busbar 20B et la face arrière 6B est ici munie du deuxième busbar 22A et du quatrième busbar 22B.

Comme cela est également visible sur la figure 9, le troisième busbar 20B est formé parallèlement au premier busbar 20A et le quatrième busbar 22B est formé parallèlement au deuxième busbar 22A.

En pratique, le troisième busbar 20B est formé à une autre distance prédéterminée du premier busbar 20A. Le quatrième busbar 22B est, quant à lui, formé à cette autre distance prédéterminée du deuxième busbar 22A. En d'autres termes, le troisième busbar 20B et le quatrième busbar 22B sont respectivement positionnés à distance (et à la même distance) du premier busbar 20A et du deuxième busbar 20B.

Avantageusement selon l'invention, l'autre distance prédéterminée est par exemple de l'ordre de la largeur de chaque busbar. De préférence, l'autre distance prédéterminée est inférieure ou égale à 100 µm. De préférence encore, l'autre distance prédéterminée est inférieure ou égale à 50 µm. En d'autres termes, le troisième busbar 20B est positionné à une distance inférieure ou égale à 100 µm (et de préférence à 50 µm) du premier busbar 20A et le quatrième busbar 22B est positionné à une distance inférieure ou égale à 100 µm (et de préférence à 50 µm) du deuxième busbar 22A.

Pour le reste, le troisième busbar 20B et le quatrième busbar 22B présentent les mêmes caractéristiques que celles décrites précédemment pour le premier busbar 20A et le deuxième busbar 22A (en particulier en ce qui concerne la largeur, la hauteur, la méthode de formation).

Ainsi, chaque cellule photovoltaïque 6 considérée, dans ce deuxième exemple, comprend sur l'une de ses faces (ici la face avant 6A), le premier busbar 20A positionné à proximité de la première portion 6C1 du bord périphérique 6C et le troisième busbar 20B qui s'étend à proximité du premier busbar 20A, et, sur l'autre de ses faces (ici la face arrière 6B) le deuxième busbar 22A positionné à proximité de la deuxième portion 6C3 du bord périphérique 6C et le quatrième busbar 22B qui s'étend à proximité du deuxième busbar 8B.

Le procédé de passivation se poursuit alors par l'étape d'empilement de la pluralité de cellules photovoltaïques 6 munies chacune, sur leur face avant 6A, de leur premier busbar 20A et de leur troisième busbar 20B et, sur leur face arrière 6B, de leur deuxième busbar 22A et de leur quatrième busbar 22B (un empilement 210 est visible sur la figure 10).

Cet empilement 210 est par exemple mis en oeuvre verticalement : les cellules photovoltaïques 6 sont alors superposées les unes sur les autres (tel que cela est représenté sur la figure 10). En variante, l'empilement peut être réalisé de manière horizontale. Dans ce cas, les cellules photovoltaïques sont positionnées les unes à la suite des autres.

De manière avantageuse selon l'invention, chaque cellule photovoltaïque 6 est positionnée de sorte que le premier busbar 20A et le troisième busbar 20B de la cellule photovoltaïque 6 concernée et le deuxième busbar 22A et le quatrième busbar 22B de la cellule photovoltaïque 6 adjacente sont placés entre cette cellule photovoltaïque 6 et la cellule photovoltaïque 6 adjacente. En d'autres termes, dans l'empilement 210, les cellules photovoltaïques 6 sont agencées les unes à la suite des autres avec le positionnement du premier busbar 20A et du troisième busbar 20B d'une cellule photovoltaïque et du deuxième busbar 22A et du quatrième busbar 22B de la cellule photovoltaïque adjacente entre deux cellules photovoltaïques adjacentes.

Cet agencement est mis en oeuvre de telle façon que la face avant 6A de la cellule photovoltaïque 6 munie du premier busbar 20A et du troisième busbar 20B est positionnée à distance de la face arrière 6B de la cellule photovoltaïque 6 adjacente munie du deuxième busbar 22A et du quatrième busbar 22B. Pour mémoire, les cellules photovoltaïques 6 considérées dans ce deuxième exemple présentent toutes la même configuration avec un premier busbar 20A et un troisième busbar 20B formés sur la face avant 6A et un deuxième busbar 22A et un quatrième busbar 22B formés sur la face arrière 6B. Les faces des cellules photovoltaïques 6 ne sont donc pas en contact entre elles lorsque qu'elles sont empilées.

Dans cette étape d'empilement, le premier busbar 20A et le troisième busbar 20B de la cellule photovoltaïque concernée sont donc positionnés en contact direct avec la face arrière de la cellule adjacente, et le deuxième busbar 22A et le quatrième busbar 22B de cette cellule photovoltaïque adjacente sont positionnés en contact direct avec la face avant de la cellule photovoltaïque 6 concernée.

En plus des avantages présentés précédemment pour le premier exemple, la configuration du deuxième exemple est particulièrement avantageuse car, grâce à la présence des troisième et quatrième busbars, elle permet de renforcer la protection des surfaces des métallisations présentes sur les faces des cellules photovoltaïques 6 (les espèces de passivation atteignent encore moins la surface des busbars 20A, 20B, 22A, 22B présents sur les faces 6A, 6B des cellules photovoltaïques).

De plus, cette configuration avec un double busbar à proximité des portions 6C1, 6C3 du bord périphérique permet de renforcer l'effet de barrière à la pénétration des espèces de passivation utilisées pour le dépôt de la couche mince. Le premier busbar 20A et le troisième busbar 20B, d'une part, et le deuxième busbar 22A et le quatrième busbar 22B, d'autre part, forment donc une double barrière pour la pénétration des espèces de passivation utilisées pour le dépôt, le long de la première portion 6C1 et de la deuxième portion 6C3 du bord périphérique 6C. Cela permet de s'assurer, d'autant plus, que, le long de la première portion 6C1 et de la deuxième portion 6C3 du bord périphérique, seul le bord périphérique 6C des cellules photovoltaïques 6 est exposé aux espèces de passivation pour le dépôt de la couche de passivation.

En variante, comme cela était décrit pour le premier exemple du deuxième mode de réalisation du procédé de passivation, avant l'étape d'empilement, il peut être prévu la formation d'éléments de protection sur chacune des faces avant et arrière, le long de la portion du bord périphérique ne présentant pas de busbars.

Ces éléments de protection sont par exemple formés, sur la face avant de chaque cellule photovoltaïque, en regard du deuxième busbar et du quatrième busbar et, sur la face arrière de la cellule photovoltaïque, en regard du premier busbar et du troisième busbar.

Grâce à ces éléments de protection, lors de l'empilement des cellules photovoltaïques, les busbars ne sont plus en contact direct avec la face en regard de la cellule adjacente mais avec l'élément de protection formé sur la face en regard. Cela permet alors d'éviter le contact direct avec la face concernée de la cellule photovoltaïque, et donc d'éviter de dégrader les performances électriques de la cellule.

## Revendications

1. Procédé de passivation de cellules photovoltaïques (5) comprenant des étapes de :
- fourniture d'une pluralité de cellules photovoltaïques, chaque cellule photovoltaïque (5) comprenant une face avant (5A), destinée à être exposée à un rayonnement incident, une face arrière (5B) opposée à la face avant (5A) et un bord périphérique (5C) reliant la face avant (5A) et la face arrière (5B), chaque cellule photovoltaïque (5) étant munie, sur la face avant (5A) ou la face arrière (5B), d'une pluralité de premières pistes conductrices d'interconnexion (8A, 9A, 10A) et d'une pluralité de deuxièmes pistes conductrices d'interconnexion (8B, 9B, 10B), la pluralité de deuxièmes pistes conductrices d'interconnexion (8B, 9B, 10B) s'étendant parallèlement à la pluralité de premières pistes conductrices d'interconnexion (8A, 9A, 10A), une pluralité de couples (8, 9, 10) de pistes conductrices d'interconnexion étant formée, chaque couple (8, 9, 10) de pistes conductrices d'interconnexion comprenant une première piste conductrice d'interconnexion (8A, 9A, 10A) parmi la pluralité de premières pistes conductrices d'interconnexion et une deuxième piste conductrice d'interconnexion (8B, 9B, 10B) parmi la pluralité de deuxièmes pistes conductrices d'interconnexion,
- empilement de la pluralité de cellules photovoltaïques (5), la pluralité de premières pistes conductrices d'interconnexion (8A, 9A, 10A) et la pluralité de deuxièmes pistes conductrices d'interconnexion (8B, 9B, 10B) de chaque cellule photovoltaïque (5) étant positionnées entre la cellule photovoltaïque (5) concernée et une cellule photovoltaïque (5) adjacente de telle manière que la face (5A, 5B) de la cellule photovoltaïque (5) munie de la pluralité de premières pistes conductrices d'interconnexion (8A, 9A, 10A) et de la pluralité de deuxièmes pistes conductrices d'interconnexion (8B, 9B, 10B) soit positionnée à distance de la face (5A, 5B) en regard de la cellule photovoltaïque (5) adjacente, et
- dépôt d'une couche de passivation sur le bord périphérique (5C) des cellules photovoltaïques (5) de la pluralité de cellules photovoltaïques par injection d'au moins une espèce de passivation.

2. Procédé de passivation selon la revendication 1, dans lequel, pour chaque couple (8, 9, 10) de pistes conductrices d'interconnexion, la première piste conductrice d'interconnexion (8A, 9A, 10A) parmi la pluralité de premières pistes conductrices d'interconnexion et la deuxième piste conductrice d'interconnexion (8B, 9B, 10B) parmi la pluralité de deuxièmes pistes conductrices d'interconnexion sont espacées d'une distance prédéterminée inférieure à 100 micromètres.

3. Procédé de passivation selon la revendication 1 ou 2, dans lequel, lors de l'étape d'empilement, les cellules photovoltaïques (5) sont positionnées de telle manière que la pluralité de premières pistes conductrices d'interconnexion (8A, 9A, 10A) et la pluralité de deuxièmes pistes conductrices d'interconnexion (8B, 9B, 10B) sont en contact direct avec la face (5A, 5B) en regard de la cellule photovoltaïque (5) adjacente.

4. Procédé de passivation selon l'une quelconque des revendications 1 à 3, dans lequel chaque cellule photovoltaïque (5) de la pluralité de cellules photovoltaïques comprend une pluralité d'électrodes (7) positionnées transversalement à la pluralité de premières pistes conductrices d'interconnexion (8A, 9A, 10A) et à la pluralité de deuxièmes pistes conductrices d'interconnexion (8B, 9B, 10B), chaque première piste conductrice d'interconnexion (8A, 9A, 10A) parmi la pluralité de premières pistes conductrices d'interconnexion et chaque deuxième piste conductrice d'interconnexion (8B, 9B, 10B) parmi la pluralité de deuxièmes pistes conductrices d'interconnexion présentant une largeur supérieure ou égale à la largeur de chaque électrode (7) de la pluralité d'électrodes.

5. Procédé de passivation selon l'une quelconque des revendications 1 à 4, dans lequel chaque cellule photovoltaïque (5) comprend également une pluralité de troisièmes pistes conductrices d'interconnexion (11C, 12C, 13C), la pluralité de troisièmes pistes conductrices d'interconnexion (11C, 12C, 13C) étant formée sur la face (5A, 5B) opposée à la face (5A, 5B) munie de la pluralité de premières pistes conductrices d'interconnexion (8A, 9A, 10A) et la pluralité de deuxièmes pistes conductrices d'interconnexion (8B, 9B, 10B).

6. Procédé de passivation selon la revendication 5, dans lequel, lors de l'étape d'empilement, les cellules photovoltaïques (5) sont positionnées de telle sorte que chaque troisième piste conductrice d'interconnexion (11C, 12C, 13C) parmi la pluralité de troisièmes pistes conductrices d'interconnexion d'une cellule photovoltaïque (5) est placée entre une première piste conductrice d'interconnexion (8A, 9A, 10A) et une deuxième piste conductrice d'interconnexion (8B, 9B, 10B) d'un couple (8, 9, 10) de pistes conductrices d'interconnexion correspondant de la cellule photovoltaïque (5) adjacente, chaque troisième piste conductrice d'interconnexion (11C, 12C, 13C) étant en contact direct avec la face (5A, 5B) de la cellule photovoltaïque (5) adjacente sur laquelle sont formées la première piste conductrice d'interconnexion (8A, 9A, 10A) concernée et la deuxième piste conductrice d'interconnexion (8B, 9B, 10B) concernée.

7. Procédé de passivation selon l'une quelconque des revendications 1 à 4, dans lequel chaque cellule photovoltaïque (5) comprend également une pluralité de quatrièmes pistes conductrices d'interconnexion (11A, 12A, 13A) et une pluralité de cinquièmes pistes conductrices d'interconnexion (11B, 12B, 13B), la pluralité de cinquièmes pistes conductrices d'interconnexion (11B, 12B, 13B) s'étendant parallèlement à la pluralité de quatrièmes pistes conductrices d'interconnexion (11A, 12A, 13A), la pluralité de quatrièmes pistes conductrices d'interconnexion (11A, 12A, 13A) et la pluralité de cinquièmes pistes conductrices d'interconnexion (11B, 12B, 13B) étant formées sur la face opposée (5A, 5B) à la face (5A, 5B) munie de la pluralité de premières pistes conductrices d'interconnexion (8A, 9A, 10A) et la pluralité de deuxièmes pistes conductrices d'interconnexion (8B, 9B, 10B), la pluralité de quatrièmes pistes conductrices d'interconnexion (11A, 12A, 13A) étant positionnée en regard de la pluralité de premières pistes conductrices d'interconnexion (8A, 9A, 10A) et la pluralité de cinquièmes pistes conductrices d'interconnexion (11B, 12B, 13B) étant positionnée en regard de la pluralité de deuxièmes pistes conductrices d'interconnexion (8B, 9B, 10B).

8. Procédé de passivation de cellules photovoltaïques (6) comprenant des étapes de :
- fourniture d'une pluralité de cellules photovoltaïques, chaque cellule photovoltaïque (6) comprenant une face avant (6A), destinée à être exposée à un rayonnement incident, une face arrière (6B) opposée à la face avant (6A) et un bord périphérique (6C) reliant la face avant (6A) et la face arrière (6B), chaque cellule photovoltaïque (6) étant munie, sur la face avant (6A), d'une première piste conductrice d'interconnexion (20A) positionnée parallèlement à une première portion (6C1) du bord périphérique (6C), chaque cellule photovoltaïque (6) étant munie, sur la face arrière (6B), d'une deuxième piste conductrice d'interconnexion (22A) positionnée parallèlement à une deuxième portion (6C3) du bord périphérique (6C), la première portion (6C1) du bord périphérique (6C) et la deuxième portion (6C3) du bord périphérique (6C) étant parallèles l'une à l'autre,
- empilement de la pluralité de cellules photovoltaïques, la première piste conductrice d'interconnexion (20A) et la deuxième piste conductrice d'interconnexion (22A) de chaque cellule photovoltaïque (6) étant positionnées entre la cellule photovoltaïque (6) concernée et une cellule photovoltaïque (6) adjacente de telle manière que la face avant (6A) de la cellule photovoltaïque (6) munie de la première piste conductrice d'interconnexion (20A) soit positionnée à distance de la face arrière (6B) de la cellule photovoltaïque (6) adjacente munie de la deuxième piste conductrice d'interconnexion (22A), et
- dépôt d'une couche de passivation sur le bord périphérique (6C) des cellules photovoltaïques (6) de la pluralité de cellules photovoltaïques par injection d'au moins une espèce de passivation, la première piste conductrice d'interconnexion (20A) et la deuxième piste conductrice d'interconnexion (22A) formant une barrière de pénétration à l'espèce de passivation de sorte que la couche de passivation recouvre le bord périphérique (6C) de chaque cellule photovoltaïque (6).

9. Procédé de passivation selon la revendication 8, dans lequel, lors de l'étape d'empilement, les cellules photovoltaïques (6) sont positionnées de telle manière que la première piste conductrice d'interconnexion (20A) et la deuxième piste conductrice d'interconnexion (22A) sont en contact direct avec la face (6A, 6B) en regard de la cellule photovoltaïque (6) adjacente.

10. Procédé de passivation selon la revendication 8 ou 9, dans lequel chaque cellule photovoltaïque (6) comprend une troisième piste conductrice d'interconnexion (20B) et une quatrième piste conductrice d'interconnexion (22B), la troisième piste conductrice d'interconnexion (20B) étant formée sur la face (6A) munie de la première piste conductrice d'interconnexion (20A), en parallèle de la première piste conductrice d'interconnexion (20A), la quatrième piste conductrice d'interconnexion (22B) étant formée sur la face (6B) munie de la deuxième piste conductrice d'interconnexion (22A), en parallèle de la deuxième piste conductrice d'interconnexion (22A), la troisième piste conductrice d'interconnexion (20B) étant formée à une distance prédéterminée de la première piste conductrice d'interconnexion (20A) et la quatrième piste conductrice d'interconnexion (22B) étant formée à ladite distance prédéterminée de la deuxième piste conductrice d'interconnexion (22A).

11. Procédé de passivation selon la revendication 10, dans lequel la distance prédéterminée est inférieure à 100 micromètres.
